## Europäisches Patentamt

## European Patent Office

## Office européen des brevets

(11) Veröffentlichungsnummer: **0 240 785**

**B1**

(12) **EUROPÄISCHE PATENTSCHRIFT**

(45) Veröffentlichungstag der Patentschrift:
25.10.89

(21) Anmeldenummer: **87103903.8**

(22) Anmeldetag: **17.03.87**

(51) Int. Cl.⁴: **C 25 D 17/06**

(54) **Haltezange.**

(30) Priorität: **11.04.86 DE 3612220**

(43) Veröffentlichungstag der Anmeldung:
**14.10.87 Patentblatt 87/42**

(45) Bekanntmachung des Hinweises auf die Patenterteilung:
**25.10.89 Patentblatt 89/43**

(84) Benannte Vertragsstaaten:
**BE CH DE ES FR GB IT LI LU NL SE**

(56) Entgegenhaltungen:
**DE-U-8 422 297**
**FR-A-1 336 501**
**GB-A-1 031 573**
**US-A-2 837 806**

**PATENT ABSTRACTS OF JAPAN, Band 7, Nr. 3 (C-143) 1148 , 7. Januar 1983; & JP - A - 57 161 093 (SUMITOMO K.K.) 04.10.1982**

(73) Patentinhaber: **SCHERING AKTIENGESELLSCHAFT Berlin und Bergkamen, Müllerstrasse 170/178 Postfach 65 03 11, D-1000 Berlin 65 (DE)**

(72) Erfinder: **Haase, Peter, Lohweg 50, D-8501 Feucht (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1989

2

## Beschreibung

Die Erfindung betrifft eine Haltezange gemäß dem Oberbegriff des Anspruches 1. Eine bekannte Haltezange gemäß dem Oberbegriff des Anspruches 1, die von der Anmelderin vertrieben wurde, sieht an der einen Zangenhälfte zwei Klemmvorsprünge und an der anderen Zangenhälfte einen Klemmvorsprung vor, der, in Längsrichtung der Zangenhälften betrachtet, mittig zwischen den beiden Klemmvorsprüngen der erstgenannten Zangenhälfte liegt. Dies hat mehrere Nachteile. Solche Zangen sollen Platten an ihren Rändern erfassen, wobei ein Pendeln der Platten um diese Erfassungsstelle vermieden, zumindest so gering als möglich gehalten werden soll. Bemißt man den Abstand zwischen den beiden Klemmvorsprüngen der einen Zangenhälfte mit L, so ist der effektiv wirksame Hebelarm aufgrund der mittigen Anordnung des Klemmvorsprunges der anderen Zangenhälfte aber nur L/2. Will man diesen Nachteil ausgleichen, so muß man entweder die Federkraft erhöhen. Dies hat aber seine Grenzen, wobei auch berücksichtigt werden muß, daß bei einer starken Federkraft die Gefahr besteht, daß die Ränder der oft sehr dünnen von der Zange zu haltenden Platten durch den mittigen Vorsprung eingedrückt werden. Vergrößert man aber den Abstand L zwischen den beiden Klemmvorsprüngen der einen Zangenhälfte, so muß der für den Halt durch die Zange zu reservierende Rand der Platte entsprechend größer gewählt werden. Der Randbereich fällt aber für das Galvanisieren aus, so daß hierdurch die effektiv noch wirksam zu galvanisierende Plattenfläche (bezogen auf Platten gleicher Außenabmessungen) entsprechend reduziert wird. Eine ähnliche im übrigen in ihrem Aufbau sehr komplizierte Zangenordnung ist Gegenstand des DE-GM-8 422 297.

Die Aufgabe der Erfindung besteht darin, eine Haltezange gemäß dem Oberbegriff des Anspruches 1 dahingehend zu verbessern, daß der für die Klemmhalterung der jeweiligen Platte zur Verfügung stehende effektive Hebelarm L verdoppelt wird, ohne dazu eine Vergrößerung des von der Haltezange zu erfassenden Randbereiches der Platten erforderlich ist.

Die Lösung dieser Aufgabe wird zunächst, ausgehend vom Oberbegriff des Anspruches 1, in den Merkmalen des Kennzeichens des Anspruches 1 gesehen. Hiermit ist der Abstand zwischen den in der Klemmlage einander gegenüberliegenden Klemmvorsprüngen jeder Zangenhälfte gleich L, also praktisch doppelt so groß wie beim Stand der Technik. Die notwendige Breite des Randbereiches der Platte, die für das Erfassen durch die Haltezange zur Verfügung stehen muß, bleibt aber die gleiche wie beim erläuterten Stand der Technik. Da erste Zangenhälfte in die beiden Zangenteile unterteilt ist, ist jedes dieser Zangenteile für sich durch Federwirkung gegen die zweite Zangenhälfte schwenkbar. Dies hat zur Folge, daß jeder der Klemmvorsprünge der Zangenteile der ersten Zangenhälfte gegenüber dem zugehörigen Klemmvorsprung der zweiten Zangenhälfte mit der entsprechenden Federkraft am Plattenrand anliegt. Der Plattenrand wird also im Abstand L von zwei Paaren sich jeweils gegenüberliegender Klemmvorsprünge mit entsprechender Klemmkraft gehalten. Änderungen in der Dicke der zu haltenden Platten beeinträchtigen die vorstehend beschriebene Funktion nicht.

Die Merkmale gemäß Anspruch 1 ermöglichen auch die vorteilhafte Anordnung einer gemeinsamen Drehachse der beiden Zangenteile gemäß Anspruch 3. Zum einen vereinfacht dies die konstruktive Gestaltung der erfindungsgemäßen Haltezange. Zum zweiten ist damit auch die Bedienung, d.h. das Verschwenken der beiden Zangenteile gegen Federwirkung entsprechend einfacher, da bei beiden Zangenteilen der Abstand des jeweiligen Angriffspunktes seitens der Bedienungsperson zur Schwenkachse der gleiche ist.

Weitere Vorteile und Merkmale der Erfindung sind den weiteren Unteransprüchen, sowie der nachfolgenden Beschreibung und der zugehörigen Zeichnung von erfindungsgemäßen Ausführungsmöglichkeiten zu entnehmen. In der Zeichnung zeigt:

Fig. 1: In einem gegenüber den weiteren Figuren verkleinerten Maßstab und schematisch die Anwendung von Haltezangen gemäß der Erfindung in einer Galvanisieranlage.

Fig. 2: Eine Haltezange nach der Erfindung in der Draufsicht,

Fig. 2a: Eine Draufsicht auf Fig. 2 gemäß dem Pfeil IIa,

Fig. 3: Eine Ansicht auf Fig. 2 gemäß dem Pfeil III,

Fig. 4, 5: In der Draufsicht bzw. Seitenansicht die zweite Zangenhälfte,

Fig. 6, 7: In der Draufsicht bzw. Seitenansicht einen Zangenteil der ersten Zangenhälfte,

Fig. 8, 9: In der Draufsicht bzw. Seitenansicht den anderen Zangenteil der ersten Zangenhälfte.

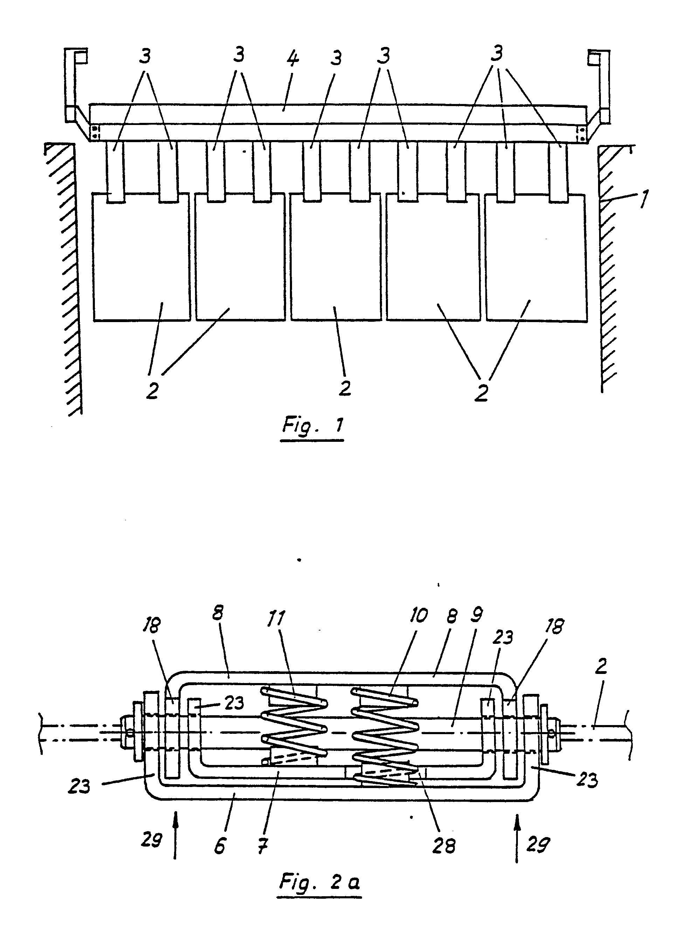

Fig. 1 zeigt in einem galvanischen Bad 1 mehrere Platten (hier Leiterplatten 2), die darin zu galvanisieren sind und von Haltezangen 3 gehalten werden, die an einem sogenannten Warenträger 4 befestigt bzw. über diesen gehängt werden. Mit Hilfe des Warenträgers 4 und der Zangen 3 können die zu galvanisierenden Leiterplatten 2 in das Bad eingesenkt bzw. nach erfolgter Galvanisierung wieder aus diesem nach oben herausgezogen werden.

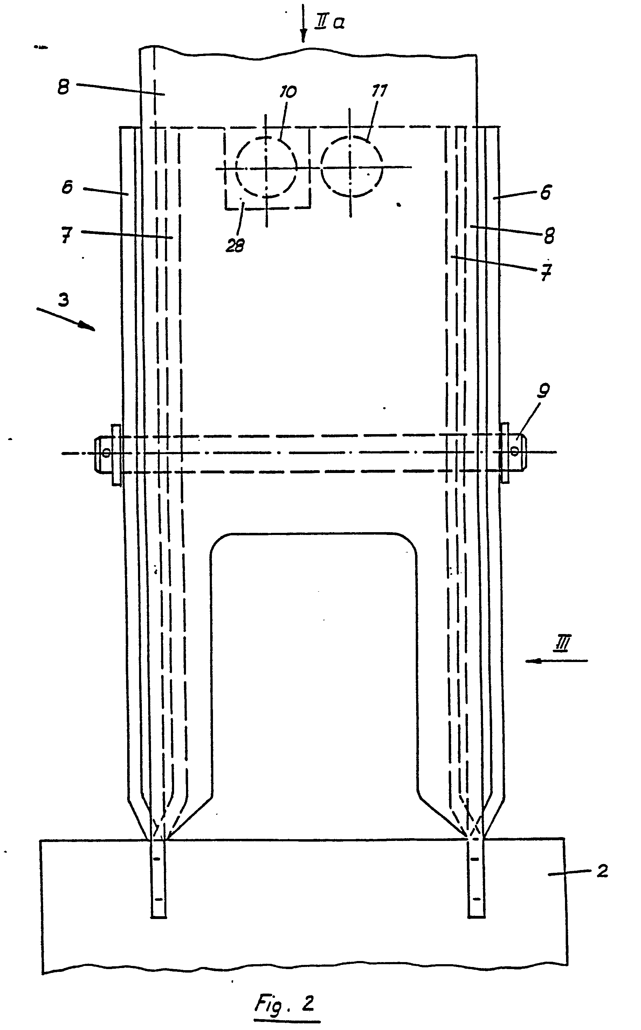

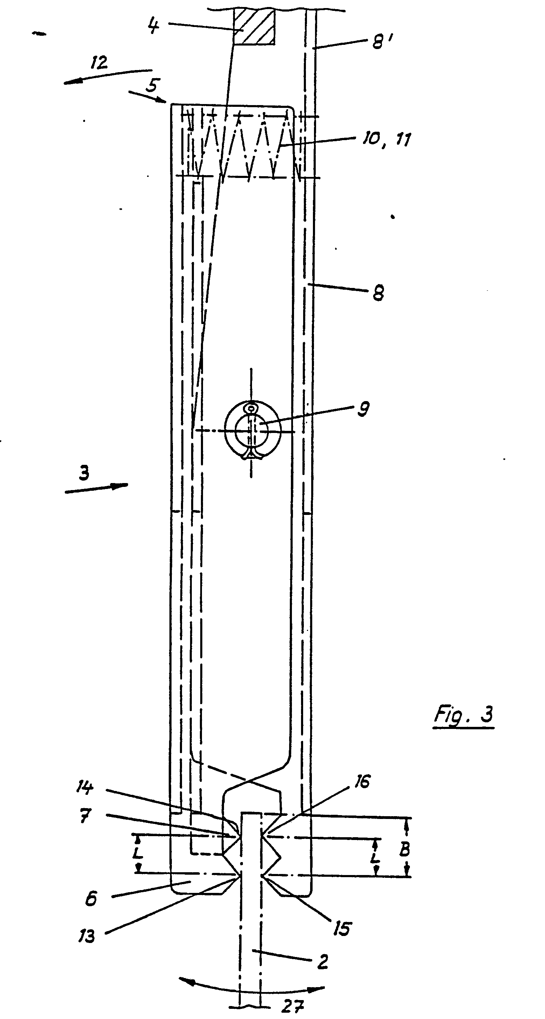

Die Figuren 2, 2a und 3 zeigen eine solche Haltezange 3, wobei die erste bewegliche Zangenhälfte 5 in zwei Zangenteile 6, 7 unterteilt ist. Die andere zweite und feste (nicht) bewegliche Zangenhälfte 8 ist mit den beiden Zangenteilen 6, 7 über eine diesen beiden Zangenteilen gemeinsame Drehachse 9 schwenkbar verbunden.

Außerdem dient der in Fig. 3 oben dargestellte Teil 8' der Zangenhälfte 8 zum Überhängen oder Befestigen der Zange an dem Warenträger 4.

Es sind zwei Druckfedern 10, 11 vorgesehen, welche die beweglichen Zangenteile 6, 7 in Richtung des Pfeiles 12 (Fig. 3) um die Achse 9 schwenken sollen. Jeder der beweglichen Zangenteile 6, 7 ist an seinem Ende mit einem Klemmvorsprung 13 bzw. 14 versehen, die einen Abstand L voneinander besitzen. Im gleichen Abstand L sind an den zweiten festen Zangenhälften 8 zwei Klemmvorsprünge 15, 16 vorgesehen, die in der Klemmlage (siehe insbesondere Fig. 3) den zugehörigen Klemmvorsprüngen 13, 14 der Zangenteile 6, 7 gegenüber liegen und zwischen sich unter Druck der Federn 10, 11 die Leiterplatte 2 festhalten. Da zu jedem beweglichen Zangenteil 6, 7 eine eigene Druckfeder 10 bzw. 11 gehört, werden diese Zangenteile je für sich verschwenkt und können daher auch je für sich mit der entsprechenden Klemmkraft an der Leiterplatte 2 anliegen. Mit derartigen Haltezangen können daher Leiterplatten unterschiedlicher Dicke sicher durch die beiden Klemmvorsprungspaare 14, 16 und 13, 15 im Abstand L erfasst werden. Dies wäre nicht möglich, wenn man die bewegliche Zangenhälfte nicht, wie es hier geschehen ist, in zwei für sich bewegliche Zangenteile unterteilt hätte. Im letztgenannten Fall würde eine Änderung der Dicke der zu haltenden Platte, z. B. einer Leiterplatte, die Folge haben, daß entweder das Klemmvorsprungspaar 14, 16 oder das andere Paar 13, 15 die jeweilige Platte nicht mehr klemmend erfassen kann.

Die Platte 2 hat die Tendenz, in Richtung des Pfeiles 27 hin und her zu schwenken. Dies muß durch die Kraft der Federn 10, 11 in Verbindung mit der Klemmhalterung und dem dabei gebildeten Hebelarm L vermieden, zumindest reduziert werden. Je größer dieser Hebelarm L bei einer möglichst kleinen nicht galvanisierbaren Breite B des Randes der Platte 2 ist, desto effektiver wird die Plattenfläche ausgenutzt. In der Praxis kann diese Breite B kleiner als 15 mm gehalten werden.

Die von den Klemmvorsprungspaaren 14, 16 und 13, 15 auszuübende Klemmkraft ist gleichmäßig.

Die Zangenhälfte 8 und die Zangenteile 6, 7 sind in einfacher Weise aus Blech stanzbar und biegbar.

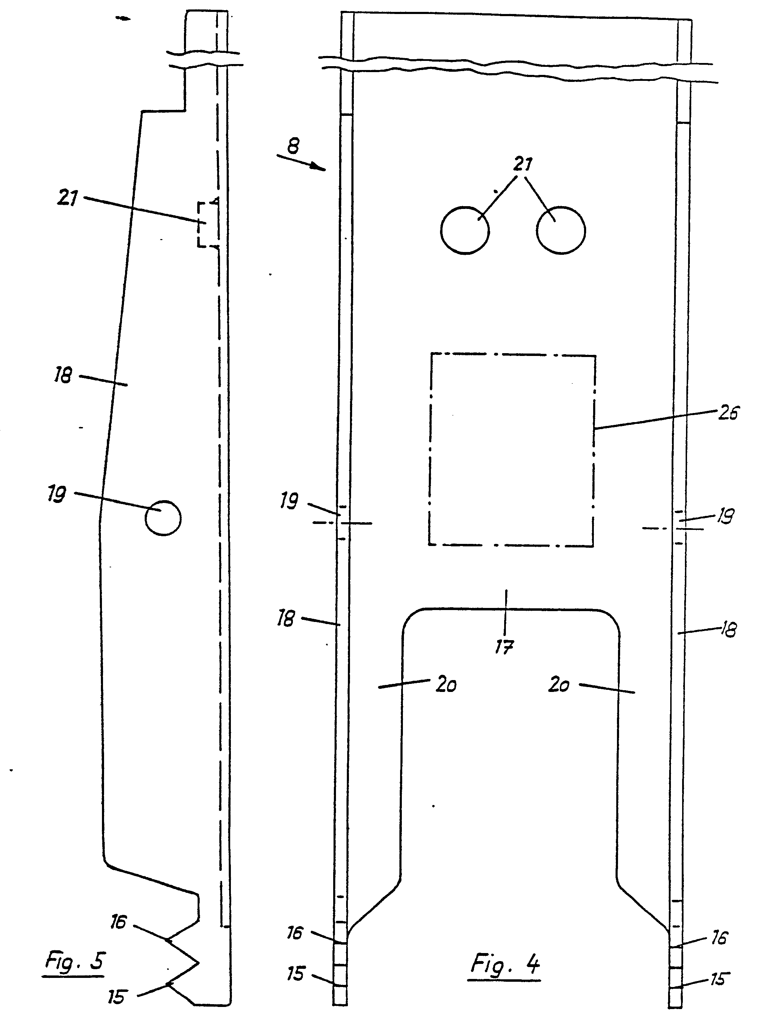

Fig. 4, 5 zeigt die zweite Zangenhälfte 8 bestehend aus einer Grundplatte 17 mit dazu im rechten Winkel abgebogenen Seitenrändern 18, die zum einen je eine Bohrung 19 zur Aufnahme der Achse 9 aufweisen. Ferner laufen die Seitenränder 18 mit Teilen 20 der Grundplatte in Arme aus, welche die Klemmvorsprünge 15, 16 tragen. Diese Klemmvorsprünge können, ebenso wie die Klemmvorsprünge 13, 14, separate, daran auswechselbar anbringbare Teile sein. Diese Klemmvorsprünge sind die am meisten beanspruchten Elemente einer solchen Haltezange. Sind sie abgenutzt, so muß nicht die gesamte Zange weggeworfen, sondern kann vielmehr durch Anbringen neuer Spitzen weiterhin funktionsfähig gehalten werden. Mit 21 sind Widerlager für das Überstecken der Druckfedern 10, 11 bezeichnet.

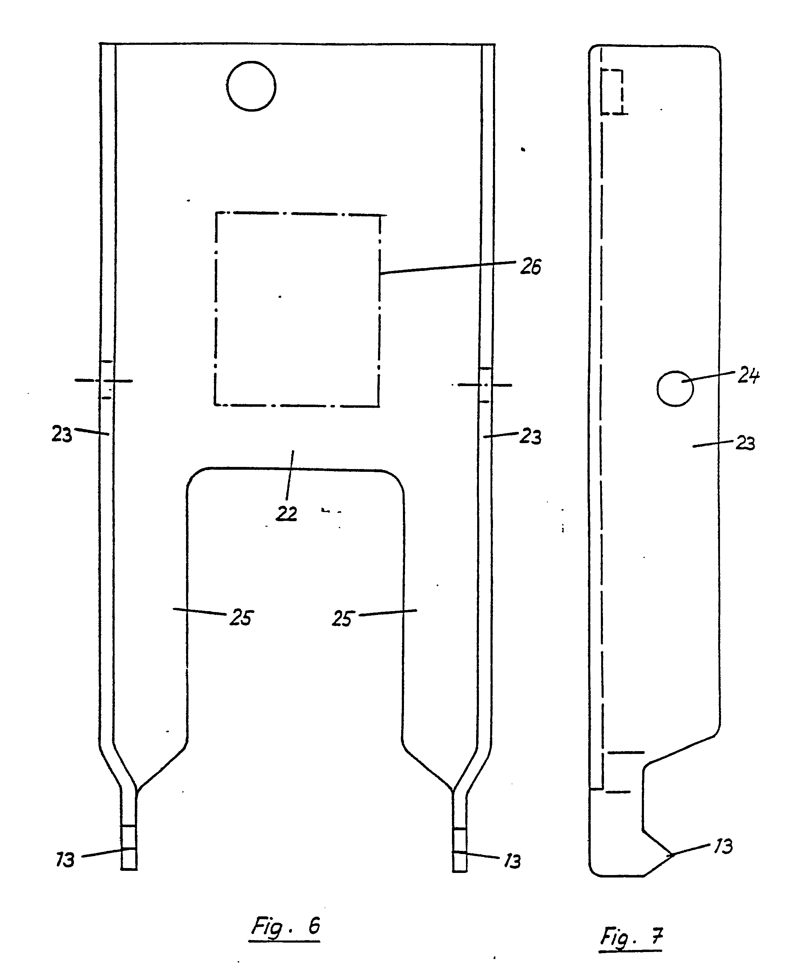

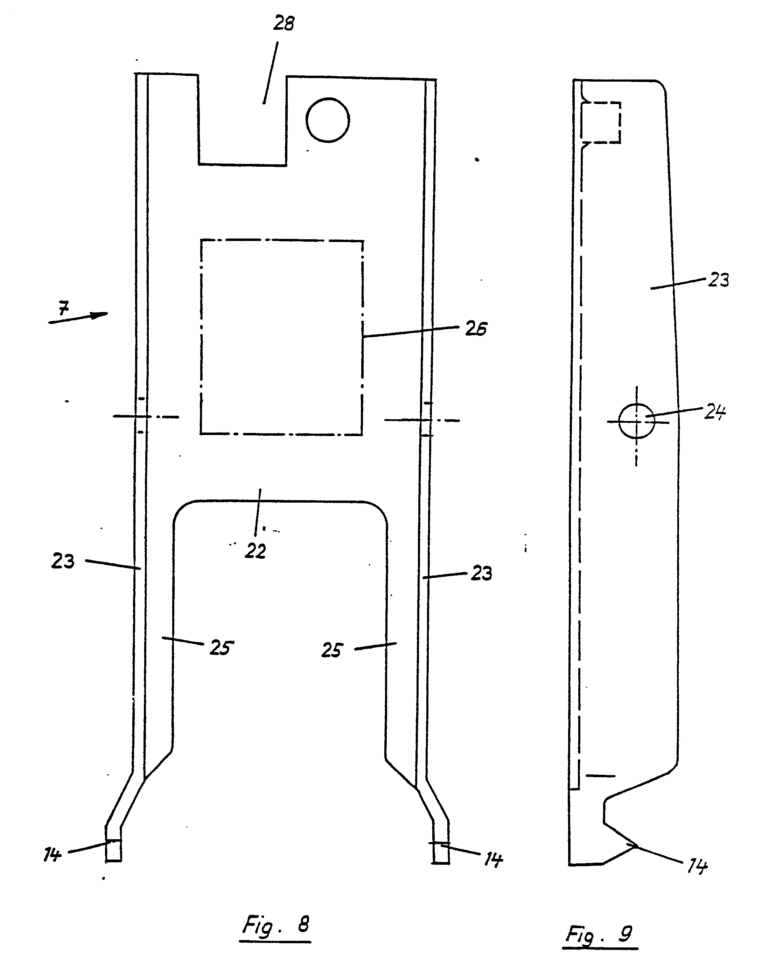

Die beiden beweglichen Zangenteile 6, 7 sind gemäß den Fig. 6, 7 und 8, 9 im wesentlichen gleich der Zangenhälfte 8 ausgebildet, nur haben sie demgegenüber etwas andere Abmessungen. Wie die beweglichen Zangenteile 6, 7 und die feste Zangenhälfte 8 räumlich ineinander passen, gewissermaßen "ineinandergeschachtelt" sind, zeigen insbesondere die Fig. 2 und 2a. Die Böden der beweglichen Zangenteile sind jeweils mit 22 und ihre abgebogenen Seitenränder mit 23 beziffert, auch hier sind in den Seitenrändern 23 Bohrungen 24 zur Aufnahme der Achse vorgesehen.

Fig. 2, 2a zeigen, daß das schmälere Zangenteil 7 eine Aussparung 28 hat, die von der Druckfeder 10 durchsetzt wird. Damit kann sich die Druckfeder 10 zwischen dem Boden des Zangenteiles 6 und der Zangenhälfte 8 abstützen, während die Druckfeder 11 sich zwischen dem Boden des Zangenteiles 7 und dem der Zangenhälfte 8 abstützt. Ein Drücken auf die in Fig. 2a unten gelegene Seite des Zangenteiles 6 hat zunächst ein Zusammendrücken der Feder 10 und danach bei Erreichen des Zangenteiles 7 auch ein Zusammendrücken der Feder 11 zur Folge, wodurch die Klemmlage (siehe Fig. 3) freigegeben wird, und die Platte 2 entfernt werden kann. Sobald die Kraft bei den Pfeilen 29 weggenommen wird, drücken die Federn 10, 11 die Zangenteile 6, 7 wieder mit ihren Klemmvorsprüngen gegen die Platte 2 beziehungsweise gegen die Klemmvorsprünge der Zangenhälfte 8.

Die von den Böden 22 und den Seiten 23 gebildeten Arme 25 tragen den jeweiligen Klemmvorsprung 13 bzw. 14. Dabei sind die Vorsprünge 14 an dem innen gelegenen und damit schmäleren beweglichen Zangenteil 7 und die Klemmvorsprünge 13 an dem demgegenüber breiteren beweglichen Zangenteil 6 vorgesehen, dessen Seiten 23 die der Zangenhälfte 8 und die des schmäleren beweglichen Zangenteiles 7 übergreifen (siehe Fig. 2a). Fig. 2a zeigt ferner, daß der Abstand zwischen den Seiten 18 der festen Zangenhälfte 8 so gewählt ist, daß die Seiten 18 zwischen den Seiten 23 der Zangenteile 6, 7 gelegen sind.

Die glatte Ausbildung der Zangenhälften bzw. Zangenteile 6, 7 und 8 erleichtert die sogenannte Spülbarkeit. Darunter versteht man in der Galvanotechnik eine Formgebung, die nach erfolgtem Bad ein leichtes und möglichst vollständiges Abspülen vorhandener Badreste (Säurereste) gestattet. Hierzu dient auch der freie Raum zwischen den jeweiligen Armen 20 bzw. 25. Außerdem kann auch der jeweils strichpunktiert mit 26 bezifferte Teil der Böden 17 bzw. 22 ausgespart oder ausgestanzt sein, um die erwähnte Spülbarkeit noch zu verbessern.

## Patentansprüche

1. Haltezange zum klemmenden Erfassen von Platten oder plattenförmigen Teilen für deren Einhängen und Herausnehmen in, bzw. aus galvanischen Bädern, wobei zwei Zangenhälften durch Federwirkung in die Klemmlage gedrückt werden und dabei mit Klemmvorsprüngen an der Platte oder dem plattenförmigen Teil anliegen, dadurch gekennzeichnet, daß die erste der Zangenhälften (5) in zwei bewegliche Zangenteile (6, 7) unterteilt ist, daß jedes dieser beweglichen Zangenteile für sich gegenüber der anderen zweiten, festen bzw. unbeweglichen Zangenhälfte (8) unter Federwirkung schwenkbar ist und daß jedes der Zangenteile (6, 7) einen Klemmvorsprung (13, 14) aufweist, dem je ein Klemmvorsprung (15, 16) der anderen Zangenhälfte (8) entspricht und in der Klemmlage (Fig. 3) gegenüberliegt.

2. Haltezange nach Anspruch 1, dadurch gekennzeichnet, daß die andere, feste bzw. unbewegliche Zangenhälfte (8) eine Halterung (8') aufweist, die am Warenträger oder dergleichen (4) einer Galvanisieranlage anhängbar ist.

3. Haltezange nach Anspruch 1 oder 2, dadurch gekennzeichnet, daß die beiden beweglichen Zangenteile (6, 7) um dieselbe Achse (9) zur festen bzw. unbeweglichen Zangenhälfte (8) schwenkbar sind.

4. Haltezange nach Anspruch 3, dadurch gekennzeichnet, daß die Zangenteile (6, 7) und die Zangenhälfte (8) zu ihrer Grundfläche bzw. ihrem Boden senkrecht stehende Seitenränder (23 bzw. 18) aufweisen, die Löcher zur Aufnahme der Schwenkachse (9) besitzen.

5. Haltezange nach einem der Ansprüche 1 - 4, dadurch gekennzeichnet, daß die Zangenteile (6, 7) und die Zangenhälfte (8) je einen Boden (22 bzw. 17) aufweisen, von dem aus sich jeweils seitlich angeordnete Arme (25 bzw. 20) erstrecken, welche die jeweiligen Klemmvorsprünge tragen.

6. Haltezange nach Anspruch 5, dadurch gekennzeichnet, daß die Böden (22 bzw. 17) der Zangenteile (6, 7) und der Zangenhälfte (8) Widerlager für die Federkraft bewirkende Druckfedern (10, 11) sind, wobei die Druckfedern (10, 11) zueinander parallel und voneinander unabhängig zur Betätigung des jeweils zugehörigen Zangeteiles (6 bzw. 7) angeordnet sind.

7. Haltezange nach einem der Ansprüche 1 - 6, dadurch gekennzeichnet, daß die Zangenteile (6, 7) und die Zangenhälfte (8) mit ihren seitlichen Rändern (23 bzw. 18) ineinander geschachtelt sind, derart, daß die Seitenränder (23) des schmal ausgebildeten Zangenteiles (7) zwischen den Seitenrändern (18) der Zangenhälfte (8) und diese zwischen den Seitenrändern (23) des breiten Zangenteiles (6) angeordnet sind.

8. Haltezange nach Anspruch 6 oder 7, gekennzeichnet dadurch, daß eine Aussparung (28) im Boden (22) des schmalen Zangenteiles (7) für den Durchtritt der dazugehörigen Feder (10) vorgesehen ist.

9. Haltezange nach einem der Ansprüche 1 - 8, dadurch gekennzeichnet, daß die Klemmvorsprünge (13 - 16) auswechselbar an den Zangenteilen (6, 7) bzw. der Zangenhälfte (8) angebracht sind.

## Claims

1. Holding pincer used to clamp boards or board-shaped parts for their suspension in and removal from electroplating baths, the two pincer halves being pressed into the clamping position by spring force and resting on the board or board-shaped parts with clamping projections, characterized in that the first of the pincer halves (5) is subdivided into two moving pincer parts (6, 7), that each of these moving pincer parts can be independently swivelled vis-à-vis the other, second, fixed or immobile pincer half (8) by spring force and that each of the pincer parts (6, 7) is provided with a clamping projection (13, 14) which respectively correspond to a clamping projection (15, 16) on the other pincer half (8) and are opposite the same in the clamped position (Fig. 3).

2. Holding pincer in accordance with Claim 1, characterized in that the other, fixed or immobile pincer half (8) is provided with a holder (8') which can be connected to the jigs or the like (4) of an electroplating plant.

3. Holding pincer in accordance with Claim 1 or 2, characterized in that the two moving pincer parts (6, 7) can be swivelled around the same axis (9) in relation to the fixed or immobile pincer half (8).

4. Holding pincer in accordance with Claim 3, characterized in that pincer parts (6, 7) and pincer half (8) have edges (23 and 18) perpendicular to their base or bottom part, these edges containing holes for the accommodation of the swivelling axis (9).

5. Holding pincer in accordance with one of Claims 1 to 4, characterized in that pincer parts (6, 7) and pincer half (8) each have a bottom part (22 and 17) from which there project, on each side, arms (25 and 20) that carry the respective clamping projections.

6. Holding pincer in accordance with Claim 5, characterized in that the bottom parts (22 and 17) of pincer parts (6, 7) and pincer half (8) form abutments for the pressure springs (10, 11) that provide the spring force, the pressure springs (10, 11) being accommodated parallel to and independent of each other for actuation of the respective pincer part (6 and 7).

7. Holding pincer in accordance with one of Claims 1 to 6, characterized in that pincer parts (6, 7) and pincer half (8) mesh with their edges (23 and 18) in such a way that the edges (23) of the narrow pincer part (7) are accommodated between the edges (18) of pincer half (8) and the latter between the edges (23) of the wide pincer part (6).

8. Holding pincer in accordance with Claim 6 or 7, characterized in that in the bottom part (22) of the narrow pincer part (7) there is a recess (28) for passage of the respective spring (10).

9. Holding pincer in accordance with one of Claims 1 to 8, characterized in that the clamping projections (13 - 16) are accommodated on the pincer parts (6, 7) and the pincer half (8) in such a way that they can be replaced.

## Revendications

1. Pince de retenue pour saisir en les bloquant des plaques ou pièces de forme similaire afin de les plonger dans des bains électrolytiques ou de les en retirer, les deux moitiés de la pince étant poussées en position bloquée par un mécanisme à ressort et adhérant ainsi à la plaque ou à la pièce de forme similaire avec leurs bosses de blocage, ladite pince étant caractérisée par le fait que la première des deux moitiés de la pince (5) est divisée en deux parties mobiles (6, 7), et que chacune de ces parties mobiles peut pivoter indépendamment de l'autre partie par effet de ressort autour de la seconde moitié de pince fixe ou immobile (8), et que chacune des parties mobiles (6, 7) présente une bosse de blocage (13, 14) à laquelle correspond une bosse de blocage (15, 16) sur l'autre moitié de la pince (8) se trouvant en face en position de blocage (fig. 3).

2. Pince de retenue selon revendication 1, ladite pince étant caractérisée par le fait que la seconde moitié de pince fixe ou immobile (8) présente une attache (8') pouvant être suspendue sur le support d'article ou dispositif similaire (4) d'une installation galvanoplastique.

3. Pince de retenue selon revendication 1 ou 2, ladite pince étant caractérisée par le fait que les deux parties de pince mobiles (6, 7) peuvent pivoter autour du même pivot (9) par rapport à la moitié de pince fixe ou immobile (8).

4. Pince de retenue selon revendication 3, ladite pince étant caractérisée par le fait que les parties de pince (6, 7) et la moitié de pince (8) présentent en leur base ou fond des bords latéraux verticaux (23 et 18) comportant des trous destinés à recevoir le pivot (9).

5. Pince de retenue selon l'une des revendications 1 à 4, ladite pince étant caractérisée par le fait que les parties de pince (6, 7) et la moitié de pince (8) présentent chacune un fond (22 et 17) à partir duquel s'étendent deux bras (25 et 20) portant les bosses de blocage correspondantes et disposés latéralement.

6. Pince de retenue selon revendication 5, ladite pince étant caractérisée par le fait que les fonds (22 et 17) des parties de pince (6, 7) et de la moitié de pince (8) constituent une butée pour les ressorts de pression (10, 11) exerçant l'effet de ressort. Ces ressorts de pression (10, 11) étant disposés parallèlement l'un par rapport à l'autre et destinés à actionner indépendamment l'un de l'autre la partie de pince correspondante (6 ou 7).

7. Pince de retenue selon l'une des revendications 1 à 6, ladite pince étant caractérisée par le fait que les parties de pince (6, 7) et la moitié de pince (8) sont emboîtées par leurs bords latéraux (23 et 18), de sorte que les bords latéraux (23) de la partie de pince étroite (7) sont disposés entre les bords latéraux (18) de la moitié de pince (8) et que ces derniers sont disposée entre les bords latéraux (23) de la partie de pince large (6).

8. Pince de retenue selon revendication 6 ou 7, ladite pince étant caractérisée par le fait qu'un évidement (28) est prévu sur le fond (22) de la partie de pince étroite (7) pour le passage du ressort correspondant (10).

9. Pince de retenue selon l'une des revendications 1 à 8, ladite pince étant caractérisée par le fait que les bosses de blocage (13 - 16) sont montées sur les parties de pince (6, 7) et sur la moitié de pince (8) de telle manière qu'il soient échangeables.

Fig. 1

Fig. 2 a

1

IIa

8

10    11

6          6

7          8

28        7

3

9

2

Fig. 2

3

EP 0 240 785 B1

Fig. 3

_Fig. 5_

_Fig. 4_

7

Fig. 6

Fig. 7

28

7

23

22

25          25

14                    14

26

_Fig . 8_

23

24

14

_Fig . 9_